Europäisches Patentamt

European Patent Office

Office européen des brevets

(19)

(11) Veröffentlichungsnummer: **0 184 680
B1**

(12) **EUROPÄISCHE PATENTSCHRIFT**

(45) Veröffentlichungstag der Patentschrift:
**22.03.89**

(21) Anmeldenummer: **85114404.8**

(22) Anmeldetag: **13.11.85**

(51) Int. Cl.⁴: **G 01 B 15/00,** H 01 J 37/244,
B 23 K 15/00

(54) **Einrichtung zum Erkennen der Auftreffstelle eines Ladungsträgerstrahls auf einem Target.**

(30) Priorität: **19.11.84 DE 3442207**

(43) Veröffentlichungstag der Anmeldung:
**18.06.86 Patentblatt 86/25**

(45) Bekanntmachung des Hinweises auf die Patenterteilung:
**22.03.89 Patentblatt 89/12**

(84) Benannte Vertragsstaaten:
**AT CH DE FR GB LI**

(56) Entgegenhaltungen:
**DE-A- 1 439 424
DE-A- 3 201 889
DE-B- 1 299 498
US-A- 4 348 576**

(73) Patentinhaber: **LEYBOLD AKTIENGESELLSCHAFT,
Wilhelm-Rohn-Strasse 25, D-6450 Hanau am Main (DE)**

(72) Erfinder: **Benes, Ewald, Dipl.-Ing. Dr. techn., Tu Wien
Karlplatz 13, A-1040 Wien (AT)**
Erfinder: **Störi, Herbert, Dipl.-Ing. Dr. phil., Tu Wien
Karlplatz 13, A-1040 Wien (AT)**
Erfinder: **Viehböck, Franz, Dr. phil. Prof., Tu Wien
Karlplatz 13, A-1040 Wien (AT)**
Erfinder: **Thomas, Friedrich-Werner, Dr.-Ing.,
Schwarzwaldweg 2, D-6460 Gelnhausen 2 (DE)**
Erfinder: **Thorn, Gernot, Dipl.-Ing., Posener Strasse 8,
D-6450 Hanau/Main 1 (DE)**

(74) Vertreter: **Schickedanz, Willi, Dipl.-Ing., Langener
Strasse 68, D-6050 Offenbach/Main (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Einrichtung zum Erkennen der Auftreffstelle eines Ladungsträgerstrahls auf einem Target, wobei die von der Auftreffstelle ausgehenden Röntgenstrahlen durch einen Detektor erkannt werden, der mit einer Auswerteschaltung verbunden ist.

Eine derartige Einrichtung wird bei Elektronenstrahl-Verdampferquellen, -Schmelzanlagen und -Schweisskanonen verwendet. Bei jeder der genannten Anlagen kommt der exakten Führung des Elektronenstrahls grosse Bedeutung zu. So wird zum Beispiel bei den Verdampferquellen der Elektronenstrahl derart über die Oberfläche des zu verdampfenden Materials geführt, dass auf einer bestimmten Fläche eine möglichst gleichmässige Oberflächentemperatur und damit eine über diese Fläche konstante Abdampfrate erzielt wird. Bei den Elektronenstrahl-Schmelzanlagen kommt es darauf an, dass der Elektronenstrahl nicht neben die aufzuschmelzenden Materialien trifft, und bei den Elektronenstrahl-Schweisskanonen muss der Elektronenstrahl exakt entlang der Trennungslinie der zu verschweissenden Teile geführt werden. Der Elektronenstrahl wird bei den genannten Anlagen über elektrische und/oder magnetische Felder auf die gewünschte Position gelenkt. Die Einstellung der Position der Auftreffstelle des Elektronenstrahls erfolgt durch entsprechende Dimensionierung und Justierung eines elektrischen oder magnetischen Ablenksystems sowie durch Anlegen geeigneter Stellgrössen in Form von elektrischen Spannungen oder Strömen an das Ablenksystem. Diese Spannungen stehen naturgemäss eher mit der Sollposition des Elektronenstrahls in direktem Zusammenhang. Die Genauigkeit der Ist-Position wird im allgemeinen nur durch entsprechend hohe Anforderungen an die zeitliche Stabilität und die Temperaturempfindlichkeit des Ablenksystems indirekt gewährleistet.

Es ist bereits eine photoelektrische Steuerrichtung für die Ablenkung eines Energiestrahls, der auf die Oberfläche eines Werkstücks auftrifft, bekannt (US-PS 3 449 542). Diese Steuerrichtung weist einen photoelektrischen Wandler auf, der eine lichtempfindliche Oberfläche besitzt, die parallel zur Oberfläche des Werkstücks ausgerichtet ist, wobei auf dieser Oberfläche der Auftreffpunkt des Energiestrahls über ein Spiegelsystem abgebildet wird. Der Wandler gibt dann, wenn ein Lichtpunkt auf seine Oberfläche fällt, über zwei Ausgangsleitungen Signale in Abhängigkeit von der Koordinatenlage des Lichtpunkts ab. Nachteilig ist bei dieser bekannten Steuerrichtung, dass ein optisches Abbildungssystem verwendet wird, das leicht verschmutzt und dann den Durchgang der Lichtstrahlen stark schwächt. Ausserdem wird nur ein kleiner Bereich der Tiegel- bzw. Bearbeitungsfläche auf dem Wandler abgebildet. Die Lage dieses Bereichs ist von der jeweils über Stellmotoren eingestellten Position eines Spiegels abhängig. Zudem ist eine über Stellmotoren einstellbare Position des optischen Abbildungssystems erforderlich, um die ganze Werkstückfläche bearbeiten zu können. Schliesslich wird bei der bekannten Steuereinrichtung als Wandler eine Photozelle verwendet, die nur Fehlersignale abgeben kann, d.h. Signale, welche die Abweichung von einem Referenzpunkt anzeigen. Ein grundsätzlicher Mangel dieser im sichtbaren Lichtbereich arbeitenden Steuereinrichtung besteht auch darin, dass sich die Auftreffstelle des Energiestrahls im sichtbaren Bereich nur sehr unscharf und mit geringem Kontrast gegenüber der restlichen Targetfläche abbildet, da wegen der thermischen Leitfähigkeit des Targetmaterials ein weit grösserer Bereich aufglüht, als es der von den Elektronen unmittelbar bombardierten Fläche entspricht, d.h. der Auftreffpunkt des Elektronenstrahls ist auf der glühenden Oberfläche des Targetmaterials in einem Tiegel mit rein optischen Mitteln nur schwer auszumachen.

Es ist indessen auch bereits ein Verfahren zum Regeln der Ist-Lage eines Strahlauftreffbereichs bezüglich eines Soll-Strahlauftreffbereichs in einem Gerät zur Bearbeitung eines Werkstücks in einem hochenergetischen Ladungsträgerstrahl bekannt, bei dem anstelle von sichtbarem Licht Röntgenstrahlen ausgenutzt werden (DE-OS 28 21 028). Hierbei wird die Soll-Lage des Strahlenauftreffbereichs aufgrund einer unterschiedlichen Röntgenemission des Soll-Strahlauftreffbereichs und einem diesem benachbarten Bereich bestimmt und bei einer etwaigen Abweichung zwischen Ist- und Sollstrahlauftreffbereich ein enstprechendes Fehlersignal zur Ausregelung der Abweichung erzeugt. Bei diesem bekannten Verfahren werden stets zwei benachbarte Bereiche mit unterschiedlicher Röntgenstrahl-Emission betrachtet, um die Soll-Position zu bestimmen. Bei homogenen Materialien versagt folglich dieses bekannte Verfahren, weil wegen der dann überall nahezu gleichen Röntgenstrahl-Emission jede Ist-Position als Soll-Position gilt. Ausserdem ist es mit Hilfe des bekannten Verfahrens nicht möglich, Ausgangssignale zu erhalten, die sich über den gesamten Tiegel- bzw. Werkstückbearbeitungs-Bereich monoton ändern, weil der Röntgenstrahlsensor kein Abbildungssystem enthält. Er weist lediglich einen Kollimator, ggf. in Form von Schlitzblenden, auf, der nur Strahlenbündel durchlässt, die einem streifen- oder punktförmigen Gesichtsfeld entsprechen. Der Sensor liefert also nur dann ein Signal wenn er auf einen Röntgenstrahlen emittierenden Punkt gerichtet ist bzw. wenn Röntgenstrahlen emittierende Punkte innerhalb des engen Erfassungsbereichs fallen.

Bei dem vorstehend erwähnten Verfahren wird zwar ein Geiger-Müller-Zählrohr verwendet, das nur eine Ja-Nein-Information abgibt, doch treten die beschriebenen Nachteile auch dann auf, wenn ein Halbleiter-Sensor verwendet wird (FR-PS 23 60 173). Derartige Halbleiter-Ionisations-Detektoren für Röntgenstrahlen sind seit längerem bekannt. Im wesentlichen sind es zwei verschiedene Typen die sich für die Erfassung von Röntgenstrahlen durchgesetzt haben. Der eine ist der lithiumdotierte Germanium-Detektor, während der andere der lithiumdotierte Silizium-Detektor ist. Wegen der engen Bandlücke bei Germanium und Silizium müssen diese Detektoren auf Temperaturen bis 77° Kelvin heruntergekühlt werden, um ihre gewünschten Eigenschaften zu erhalten. Si(Li)-Detektoren werden im allgemeinen für die Messung von Röntgenstrahlen geringer Energie verwendet, weil ihre Auflösung höher als die von Ge(Li)-Detektoren ist. Bei höheren Röntgenstrahlenergien werden (Gi(Li)-Dedektoren bevorzugt, weil sie einen grösseren photoelektrischen Querschnitt aufweisen (The New Encyclopaedia Britannica, 1977, Macropaedia, Band 19, S. 1063, rechte Spalte).

Es ist ausserdem eine Vorrichtung bekannt, die mittels eines Elektronenstrahls arbeitet, wobei dieser Elektronenstrahl von einer Elektronenstrahlkanone erzeugt und auf ein Werkstück konzentriert wird (Japanische Patentveröffentlichung 38-5955 vom 14. Mai 1963). Ein Teil der Röntgenstrahlen, die durch die Elektronen erzeugt werden, wird auf einen Detektor gegeben, der ein Signal auf eine elektronische Schaltung gibt, welche eine Ablenkelektrodenplatte steuert, so dass das Signal des Detektors ein Maximum wird. Nachteilig ist bei dieser bekannten Vorrichtung, dass mit ihr nicht die absolute Position des Elektronenstrahls erfasst werden kann, sondern dass sie lediglich eine «Ja/Nein»-Aussage darüber zulässt, ob sich der Strahl innerhalb oder ausserhalb einer Position befindet. Befindet sich der Strahl nicht in der richtigen Position, so wird eine Korrekturschaltung aktiviert, die Strom zuführt, um ein «Ja»-Signal zu erhalten. Solange die Vorrichtung im «Ja»-Zustand verharrt, wird kein Korrektursignal erzeugt. Es sind bei dieser bekannten Vorrichtung auch keine Detektoren vorgesehen, welche ihre Ausgangssignale monoton in Abhängigkeit von einer Eingabeposition ändern.

Der Erfindung liegt die Aufgabe zugrunde, eine Einrichtung zum Erkennen der Auftreffstelle eines Landungsträgerstrahls auf einem Target zu schaffen, wobei die von der Auftreffstelle ausgehenden Röntgenstrahlen durch einen Detektor erkannt werden, der mit einer Auswerteschaltung verbunden ist und wobei alle möglichen Auftreffstellen des Ladungsträgerstrahls koordinatenmässig exakt erfasst werden.

Diese Aufgabe wird erfindungsgemäss dadurch gelöst, dass ein Abbildungssystem vorgesehen ist, welches alle Positionen, welche die Auftreffstelle einnehmen kann, erfasst und auf die Sensorfläche eines positionsempfindlichen Detektors abbildet, wobei die abgebildeten Koordinaten direkt proportional den Koordinaten der Auftreffstelle sind, und das zwischen Targetfläche und positionsempfindlichem Sensor ein im wesentlichen in dem von der Auftreffstelle emittierten Röntgen-Wellenlängenbereich der von der Auftreffstelle emittierten Strahlung gut durchlässiges Filter angeordnet ist und der Detektor elektrische Signale abgibt, die von den Koordinaten der Auftreffstelle monoton abhängen.

Der mit der Erfindung erzielte Vorteil besteht darin, dass im Gegensatz zu einer Abbildung des Auftreffpunkts mit Hilfe sichtbarer Lichtstrahlen bei einer Abbildung mit Hilfe von Röntgenstrahlen der Auftreffpunkt von seinem Umfeld klar unterscheidbar ist, denn nur dort, wo ein Ladungsträgerstrahl auftrifft, werden Röntgenstrahlen emittiert. Treffen Ladungsträger auf Materie, so werden sie gebremst. Die fliegenden Ladungsträger verlieren bei den bremsenden Stössen Energieportionen verschiedener Grösse. Es entsteht dabei eine kontinuierliche Bremsstrahlung mit verschiedenen Frequenzen. Das kontinuierliche Spektrum der Röntgenbremsstrahlung erstreckt sich bis zu einer bestimmten maximalen Grenzfrequenz oder einer kurzwelligen Grenze, wobei die spektrale Verteilung des Strahlungsflusses der Röntgenbremsstrahlung von den kinetischen Energien der Ladungsträger, vorzugsweise der Elektronen, abhängen. Es ist im wesentlichen diese Bremsstrahlung, die bei der Erfindung ausgenützt wird.

Neben der Röntgen-Bremsstrahlung gibt es auch noch die sogenannte charakteristische Röntgenstrahlung, die charakteristisch für den Stoff ist, auf den die Ladungsträger treffen. Charakteristische Röntgenstrahlung wird emittiert, wenn ein Elektron in eine innere, dem Kern nähere Schale eines Atoms springt. Dazu muss vorher ein Platz in einer vollbesetzten Schale frei gemacht werden, d.h. es muss eine Anregung stattfinden, die eine relativ grosse Energie erfordert. Diese Energie wird beispielsweise durch Elektronenstoss aufgebracht. Die auftreffenden Ladungsträger müssen also sehr schnell, d.h. durch hohe Spannungen (materialabhängig etwa zwischen 2 KV und 60 KV) beschleunigt worden sein. Die charakteristische Röntgenstrahlung ist als Linienspektrum zu erkennen, das dem kontinuierlichen Spektrum der Bremsstrahlung überlagert ist. Die charakteristische Strahlung kann im Prinzip ebenfalls für die Realisierung der Erfindung verwendet werden. Sie ist jedoch im Vergleich zur Röntgenbremsstrahlung für die Erfindung von geringerer Bedeutung.

Ausführungsbeispiele der Erfindung sind in der Zeichnung dargestellt und werden im folgenden näher beschrieben. Es zeigen:

Fig. 1 eine Prinzipstellung der Erfindung, wobei eine Lochblende zwischen Elektronenstrahl-Auftreffpunkt und Sensor vorgesehen ist;

Fig. 2 eine weitere Prinzipstellung der Erfindung, wobei eine Schlitzblende zwischen Elektronenstrahl-Auftreffpunkt und Sensor vorgesehen ist;

Fig. 3 eine Blende mit Filterfolie;

Fig. 4 eine Lichtleiterplatte, die zwischen einem Sensor und einer Fluoreszensschicht angeordnet ist;

Fig 5. eine zweidimensionale Lateraldiode mit Auswerteschaltung;

Fig. 6 eine eindimensionale Lateraldiode mit Auswerteschaltung.

Fig. 7 einen Tiegel mit Targetmaterial und auftreffendem Elektronenstrahl, wobei mehrere Detektoren vorgesehen sind.

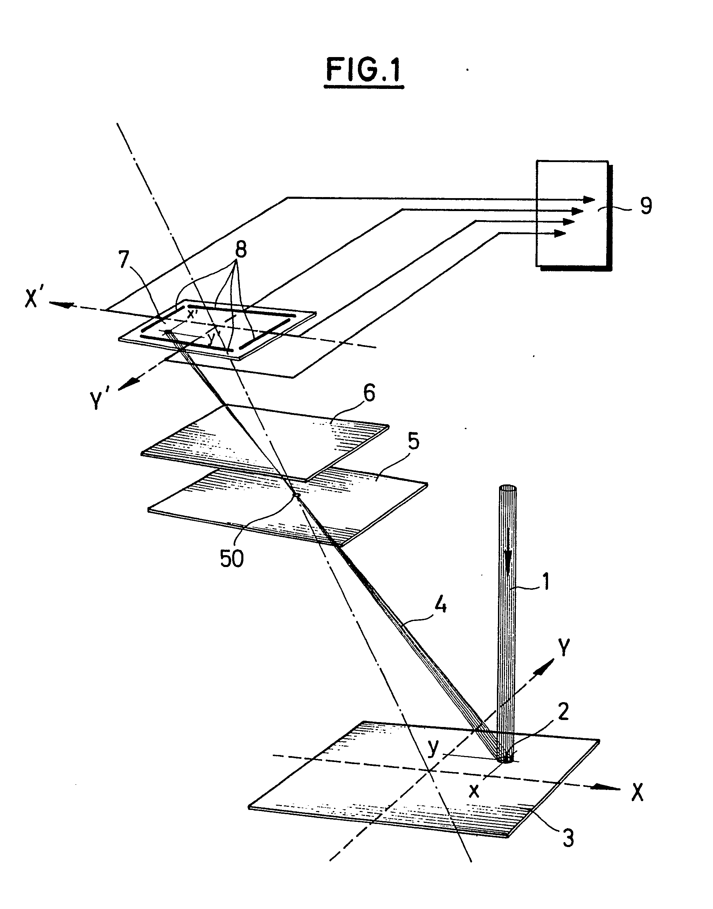

Bei der Prinzipdastellung der Fig. 1 ist ein Elektronenstrahl 1 gezeigt, der an einer Stelle 2 auf ein Targetmaterial 3 auftrifft. Mit X bzw. Y sind die Koordinatenachsen bezeichnet, welche die Koordinaten x und y der Auftreffstelle 2 festlegen. Von der Auftreffstelle 2 gehen Röntgenstrahlen aus, von denen nur das Röntgenstrahlenbündel 4 dargestellt ist. Hierbei ist sowohl die emittierte charakteristische Röntgenstrahlung als auch die Röntgenbremsstrahlung direkt proportional der Dichte der auf das Targetmaterial aufprallenden Elektronen. Die Röntgenstrahlen werden nur von der Auftreffstelle 2 ausgesendet, wobei das Intensitätsmaximum der emittierten Röntgenstrahlung bei der üblichen Gauss-Verteilung der Elektronenstrahlintensität im Zentrum der Auftreffstelle 2 des Elektronenstrahls 1 liegt.

Das von der Auftreffstelle 2 ausgehende Röntgenstrahlenbündel 4 durchläuft eine Lochblende 5 sowie eine Filterfolie 6. Diese Filterfolie 6 besteht beispielsweise aus einer wenige Mikrometer dicken Aluminium-Folie, die Röntgenstrahlen mit geringer Abschwächung passieren lässt. Nachdem das Röntgenstrahlenbündel 4 die Folie 6 durchlaufen hat, wird es auf einem positionsempfindlichen Detektor 7 abgebildet. Dieser positionsempfindliche Detektor 7 kann eine Diodenmatrixanordnung, eine CCD-Anordnung, eine Lateraldiode oder ein sonstiges geeignetes Bauelement sein.

Für die Detektion des durch Röntgenstrahlen über die Lochblende 5 entworfenen Bilds der Auftreffstelle 2 des Elektronenstrahls 1 werden zweckmässigerweise Halbleiterdioden eingesetzt, wobei am einfachsten deren direkte Röntgenstrahlenempfindlichkeit ausgenutzt werden kann. Hierfür sind offene Photodioden ohne Deckglas mit einer möglichst dicken Sperrschicht gut geeignet. Da diese aber auch im sichtbaren, in geringem Ausmass auch im infraroten und ultravioletten Spektralbereich empfindlich sind und diese Bereiche der elektromagnetischen Strahlung keine brauchbaren Bildinformationen liefern, ist zwischen der Auftreffstelle 2 des Elektronenstrahls 1 und dem Detektor 7 die Folie 6 vorgesehen. Als besonders vorteilhaft für die Realisierung der Erfindung haben sich optische Positionsdetektoren erwiesen, deren Messprinzip auf lateralen Photoeffekten an der Oberfläche einer grossflächigen PIN-Diode beruhen. Derartige Positionsdetektoren geben Signale für die X- und Y-Richtung aus (vergl. H.P. Siebert, Optische Positionsdetektoren PSD: Völlig aufgelöst ..., Zeitschrift ELEKTRONIK. Nr.13, 1984, Seiten 84–88; Zeitschrift Industrie-elektik + elektonik, 1983, Nr. 8, S. 21, 22). Ihre Funktionsweise wird im Zusammenhang mit der weiter unten beschriebenen Auswerteschaltung noch eingehender erörtert.

Für die Abbildung des von der Auftreffstelle 2 ausgehenden Röntgenstrahlenbündels 4 wird im Ausführungsbeispiel der Fig. 1 das Lochkameraprinzip angewendet. Es können hierfür aber auch Abbildungssysteme nach dem Fresnelzonen-Prinzip oder nach dem Röntgen-Linsen-Prinzip verwendet werden. Röntgenlinsen werden bereits seit langem in der Röntgenmikroskopie verwendet; sie bestehen aus rotationssymmetrischen Körpern mit aufgeschichteten Kristallen. Das Lochkameraprinzip ist indessen besonders einfach und problemlos. Die Grösse des Blendenlochs 50 in der Lochblende 5 ergibt sich hierbei entsprechend dem gewünschten Kompromiss zwischen hoher Ortsauflösung bei kleinem Blendenloch 50 und ausreichendem Röntgenstrahlenfluss bei grossem Blendeloch 50. Der Abbildungsmassstab, das heisst das Verhältnis der Bildkoordinaten x' und y' zu den Gegenstandskoordinaten x bzw. y ist gleich dem Verhältnis der Abstände zwischen Blendenloch 50 und Detektor 7 einerseits und Blendeloch 50 und Oberfläche des Targetmaterials 3 andererseits. In der Fig. 1 ist nur eine Lochblende 5 dargestellt. Es können jedoch auch zwei Lochblenden vorgesehen sein, von denen die eine für die Abbildung der X-Koordinate und die andere für die Abbildung der Y-Koordinate dient. Die von dem Detektor 7 erzeugten Signale werden über Elektroden 8 einer Auswerteschaltung 9 zugeführt, die Ströme oder Spannungen liefert, welche zu den Bildkoordinaten x', y' proportional sind.

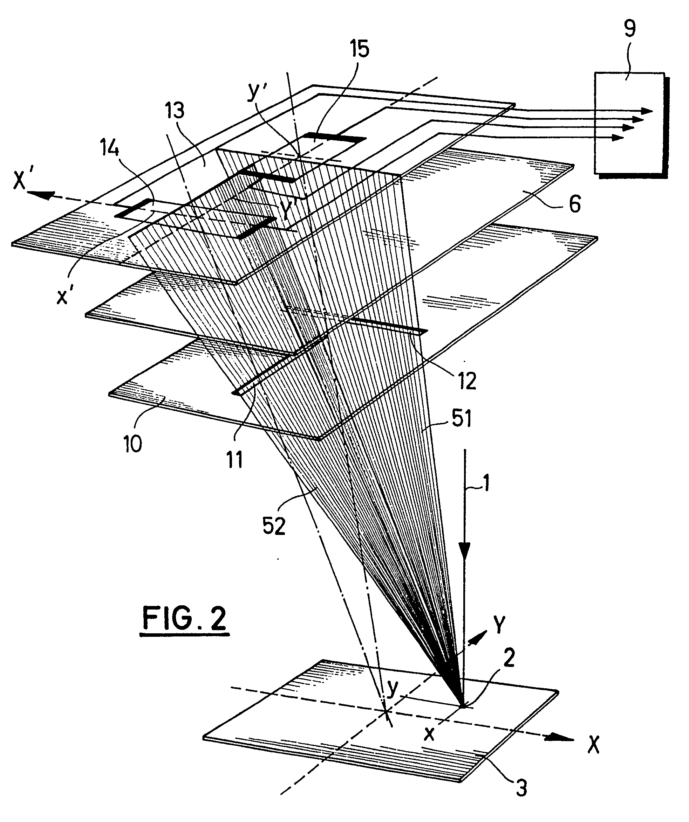

In der Fig. 2 ist der Elektronenstrahl 1 zur Vereinfachung der Darstellung mit verschwindendem Durchmesser dargestellt. Die von der Auftreffstelle 2 des Elektronenstrahls 1 ausgehenden Röntgenstrahlen, von denen nur die beiden Bündel 51, 52 dargestellt sind, werden über eine Schlitzblende 10, die zwei rechtwinklig zueinander angeordnete Schlitze 11 und 12 enthält, ausgeblendet und über eine Filter-Folie 6 auf einen Detektor 13 gegeben, die zwei Sensoren 14, 15 enthält, deren Längsachsen senkrecht aufeinander stehen. Diese Sensoren 14, 15 sind mit der Auswerteschaltung 9 verbunden. Die Breite der Schlitze 11, 12 ergibt sich wieder aus dem Kompromiss zwischen Ortsauflösung und Intensität. Die Länge des Schlitzes 11 wird so gewählt, dass in jedem Fall aureichend Röntgenstrahlen auf den Sensor 15 fallen. Die beiden Schlitze 11, 12 der Schlitzblende 10 bilden den Auftreffpunkt 2 des Elektronenstrahls 1 nicht exakt im Sinne einer photographischen Abbildung auf den Sensoren ab. Unter einer Abbildung im Sinne der Erfindung wird deshalb nicht nur eine kameramässige Abbildung verstanden, sondern auch eine solche Abbildung, bei der die Koordinaten der Auftreffstelle 2 des Elektronenstrahls dem Schwerpunkt der örtlichen Elektronenstrahldichteverteilung auf der Targetfläche 3 entsprechen. Als Schwerpunkt wird hierbei der geometrische Schwerpunkt z.B. einer Kurve mit zwei oder mehr Höckern verstanden. Der Schlitz 11 dient zum Abbilden der x-Koordinaten auf dem Sensor 14, während der Schlitz 12 für die Abbildung der y-Koordinaten auf dem Sensor 15 vorgesehen ist.

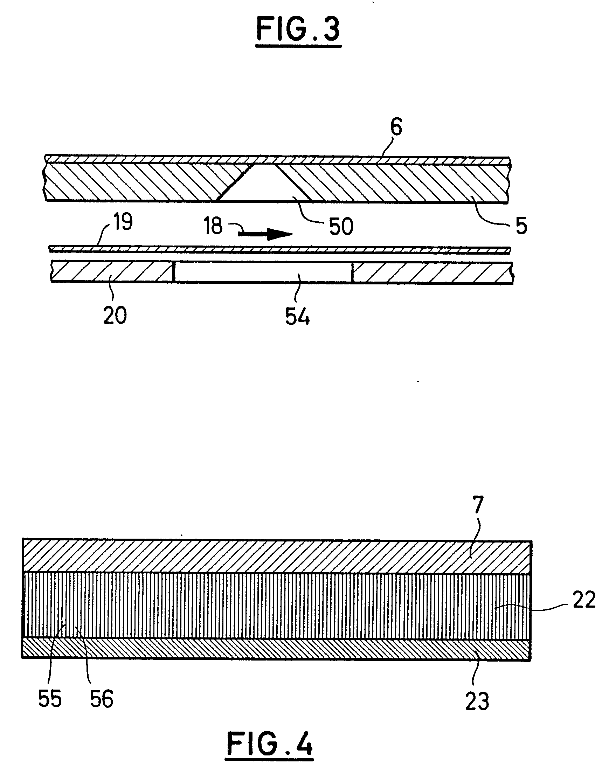

In der Fig. 3 ist die Filterfolie 6 zusammen mit der Lochblende 5 dargestellt. Die Filterfolie 6 besteht vorzugsweise aus Aluminium, während die Lochblende 5 aus Blei oder Tantal bestehen kann. Filterfolie 6 und Lochblende 5 sind hierbei dicht aufeinander gelegt.

Die Kombination aus Filterfolie 6 zur Lochblende 5 kann in vorteilhafter Weise als vakuumdichte Trennwand zwischen dem Hochvakuum des Target- bzw. Elektronenstrahlraums und der zweckmässig im normalen Atmosphärendruck befindlichen Detektors 7 eingesetzt werden. Zwischen der Lochblende 5 und einer Aufdampfblende 20 ist eine Schutzfolie 19 vorgesehen. Der Pfeil 18 gibt die Bewegungsrichtung dieser Folie 19 an. Die Schutzfolie 19 kann gegebenenfalls durch eine zu bedampfende Folie realisiert werden. Das Targetmaterial befindet sich unterhalb der Aufdampfblende 20, während sich das Detektorsystem oberhalb der Schutzfolie 6 befindet. Die Aufdampfblende 20 bewirkt eine Reduktion der jeweils bedampften Fläche der Folie 19. Die Wahl des Durchmessers der Aufdampf-Blendenöffnung 54 ist nach unten dadurch begrenzt, dass durch die Aufdampfblende 20 keine Abschirmung der für die Abbildung der Auftreffstelle 2 des Elektronenstrahls 1 notwendigen Röntgenstrahlen erfolgen darf.

In der Fig 4. ist eine Ausgestaltung der Detektoreinrichtung gezeigt. Unterhalb des Detektors 7 ist eine Lichtleiterplatte 22 vorgesehen, die aus mehreren, parallel zueinander verlaufenden Lichtleitfasern besteht, von denen nur zwei Lichtleitfasern 55, 56 mit Bezugszahlen versehen sind. Diese Lichtleiterplatte 22 lässt keine Lichtbrechung zu, sondern führt das Licht senkrecht von unten nach oben. Mit der Bezugszahl 23 ist eine Fluoreszensschicht bezeichnet, die sich unterhalb der Lichtleiterplatte 22 befindet. Diese Fluoreszensschicht 23 wandelt Röntgenstrahlen in sichtbares Licht um, so dass der Detektor 7 nur mit sichtbarem Licht beaufschlagt wird, das aus Röntgenstrahlen gewonnen wurde. Hierdurch wird die Röntgenbelastung des Detektors 7 reduziert und damit eine Strahlenschädigung dieses Detektors 7 verhindert. Bei Verwendung der Fluoreszensschicht 23 kann auf ein zusätzliches Filter, das nur Röntgenstrahlen durchlässt, dann verzichtet werden, wenn diese Fluoreszensschicht ausschliesslich auf Röntgenstrahlen anspricht. Die Fluoreszensschicht ist in diesem Falle gewissermassen selbst dieses Filter, denn sie lässt nur Röntgenstrahlen durch, und zwar in umgewandelter Form. Man kann die Fluoreszensschicht 23 auch als Stokes'schen Frequenzwandler ansehen, der höhere Frequenzen in niedrigere Frequenzen umformt.

Um zu den x- und y-Koordinaten streng proportionale Ausgangsspannungen zu erhalten, sieht die Erfindung vor, dass als Detektoren am besten zweidimensionale Lateraldioden, die auch unter der Bezeichnung PSD (= Position Sensitive Detectors) bekannt sind, verwendet werden, sofern es sich um nur eine Lochblendenabbildung oder dergleichen handelt. Wird dagegen mit zwei Lochblenden oder mit zwei Schlitzblenden abgebildet, so wird als Detektor vorzugsweise eine eindimensionale Lateraldiode für eine Koordinate und eine andere eindimensionale Lateraldiode für die andere Koordinate verwendet. Bei den Lateraldioden handelt es sich um grossflächige PN-, PIN- oder Schottky-Dioden, bei denen ein Teil der in der Sperrschicht absorbierten Lichtquanten Elektronen-Lochpaare erzeugt. Diese Ladungsträger teilen sich je nach ihrer Entfernung von den Elektroden am Rande der Schicht auf die Elektroden auf, wodurch aus dem Verhältnis der Elektrodenströme auf die Auftreffstelle des Lichtquants geschlossen werden kann. Bisher wurden diese Dioden nur im sichtbaren Bereich elektromagnetischer Strahlung verwendet; sie zeigen jedoch auch eine für die erfindungsgemässe Anwendung ausreichende direkte Empfindlichkeit im Röntgenbereich. Si-Lateraldioden zeigen ein Maximum der direkten Röntgenempfindlichkeit bei einer Quantenenergie von rund 10 keV, GaAs-Lateraldioden zeigen bei höheren Quantenenergien eine weit höhere Quantenausbeute als Si-Lateraldioden. GaAs-Lateraldioden werden deshalb vorteilhaft bei hohen Quantenenergien und niedrigen Röntgenintensitäten eingesetzt.

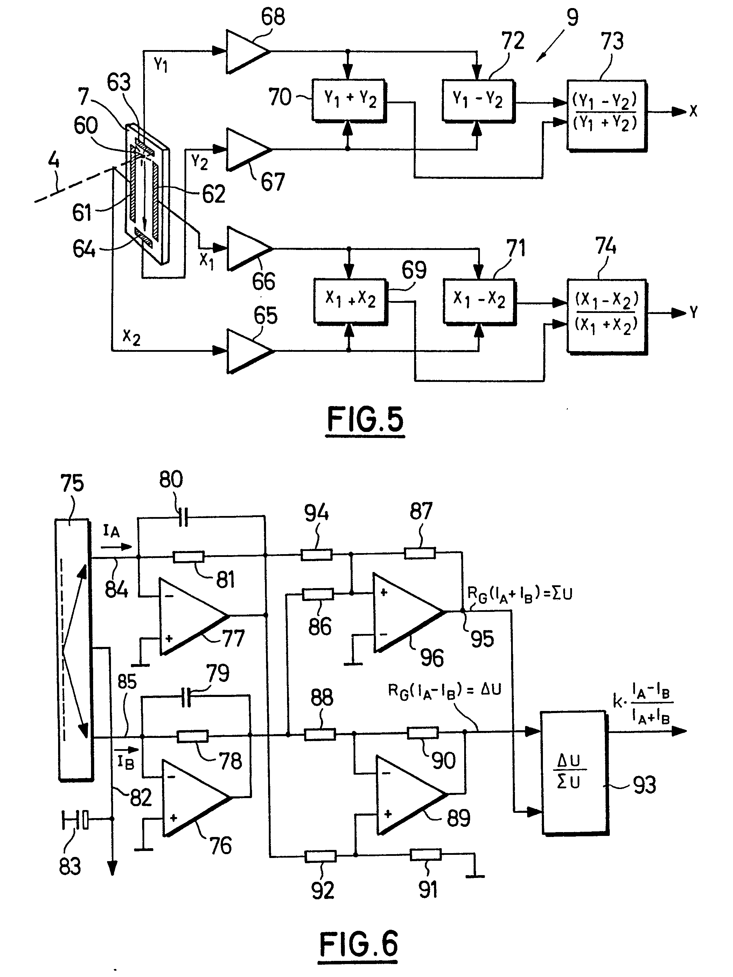

In der Fig. 5 ist ein Blockschaltbild einer Auswerteschaltung dargestellt, welche die Signale einer zweidimensionalen Lateraldiode auswertet. Diese Auswerteschaltung ist bereits als solche für die Verwendung im sichtbaren Bereich elektromagnetischer Strahlung bekannt (vergl. «industrie-elektrik + elektronik, a.a.O., S. 22).

Ein Röntgenstrahlbündel 4 fällt auf einen Punkt 60 des Detektors 7, der als zweidimensionale Lateraldiode ausgebildet ist und vier Elektroden 61, 62, 63, 64 hat. Die Elektroden 61, 62 sind hierbei den x-Koordinaten zugeordnet, während die Elektroden 63, 64 den y-Koordinaten zugeordnet sind. Alle Elektroden 61–64 sind mit Vorverstärkern 65–68 verbunden, die zu Additionsschaltungen 69, 70 bzw. Subtraktionsschaltungen 71, 72 führen. In diesen Schaltungen 69–72 werden die den x- bzw. y-Koordinaten zugeordneten Ausgangssignale des Detektors 7 jeweils für sich addiert bzw. subtrahiert. Die Ausgangssignale der Additionsschaltung 70 und der Subtraktionsschaltung 72 werden auf einen Dividierer 73 gegeben, der das Ausgangssignal der Subtraktionsschaltung 72 durch das Ausgangssignal der Additionsschaltung 73 dividiert. Durch diese Division wird die Intensitätsabhängigkeit der Signale eliminiert, und es tritt am Ausgang des Dividierers 73 ein Signal auf, das nur noch von der Koordinate X abhängt.

In entsprechender Weise erfolgt die Signalverarbeitung für die Koordinate Y. Hierzu werden die Ausgangssignale der Vorverstärker 65, 66 addiert bzw. subtrahiert und anschliessend die Ausgangssignale des Subtrahierers 71 durch die Ausgangssignale des Addierers 69 im Dividierer 74 dividiert. Am Ausgang des Dividierers 74 steht dann ein Signal an, das nicht mehr von der Intensität der im Punkt 60 auftreffenden Strahlen abhängt, sondern nur noch von der Y-Koordinate dieses Punkts 60.

In der Fig. 6 ist eine Schaltungsanordnung gezeigt, welche eine eindimensionale Lateraldiode 75 enthält, mit der es möglich ist, eine Koordinate zu erfassen. Zwei dieser Lateraldioden 75 können beispielsweise in der Einrichtung gemäss Fig. 2 verwendet werden. Die der Lateraldiode 75 nachgeschaltete Anordnung entspricht im wesentlichen dem unteren oder oberen Zweig der in der Fig. 5 gezeigten Anordnung. Der Lateraldiode 75, deren Mittelpunkt über eine Leitung 82 und einen Kondensator 83 an einer Vorspannung liegt, weist zwei Ausgänge 84, 85 auf, von denen der eine Ausgang 84 den Strom $i_A$ und der andere Ausgang 85 den Strom $i_B$ führt. Der Strom $i_A$ gelangt auf einen Vorverstärker 77 mit einer aus einem Widerstand 81 und einem Kondensator 80 bestehenden Parallelschaltung im Rückführungszweig. In entsprechender Weise gelangt der Strom $i_B$ auf einen Vorverstärker 76 mit einer aus einem Widerstand 78 und einem Kondensator 79 bestehenden Parallelschaltung im Rückführungszweig. Der Ausgang des Vorverstärkers 77 ist über einen Widerstand 94 mit dem positiven Eingang eines Addierverstärkers 96 verbunden. An demselben positiven Eingang des Addierverstärkers 85 liegt über einen Widerstand 86 auch der Ausgang des Vorverstärkers 76. Die Ausgangssignale beider Vorverstärker 76, 77 werden somit in dem Addierverstärker 96, der einen Widerstand 87 in der Rückführung aufweist, addiert, d.h. am Ausgang des Addierverstärkers 96 steht ein Signal an, das der Summe $i_A + i_B$ proportional ist.

Das Ausgangssignal des Vorverstärkers 76 wird auch noch über einen Widerstand 88 dem negativen Eingang eines Subtraktionsverstärkers (89 zugeführt, der in seinem Rückführungszweig einen Widerstand 90 aufweist. Der positive Eingang des Subtraktionsverstärkers 89 ist über einen Widerstand 91 an Masse gelegt und über einen weiteren Widerstand 92 mit dem Ausgang des Vorverstärkers 76 verbunden. Durch diese Beschaltung werden die Ausgangssignale der beiden Vorverstärker voneinander subtrahiert, und zwar $i_B$ von $i_A$.

Die in der Fig. 6 gezeigte Additions- bzw. Subtraktionsschaltung gehört seit langem zum Stand der Technik und wird deshalb nicht eingehender beschrieben (vergl. hierzu Beuth/Schmusch: Grundschaltungen der Elektronik, Band 3, 4. Auflage, 1981, S. 144–147).

Die Ausgangssignale der Additions- bzw. Subtraktionsverstärker 85, 89 werden wieder wie in Fig. 5 auf einen Dividierer 93 gegeben, der das Differenzsignal durch das Additionssignal dividiert. Am Ausgang dieses Dividierers steht dann ein Signal an, das einer Koordinate, z.B. der x-Koordinate, zugeordnet ist.

Die Ausgangssignale der Dividierer 73, 74 (Fig. 5) bzw. 93 (Fig. 6) können beispielsweise für die genaue Erfassung der Ist-Position des Auftreffpunkts 2 des Elektronenstrahls 1 auf dem Targetmaterial verwendet werden. Diese Ist-Positionen können ihrerseits wieder verwendet werden, um den Elektronenstrahl 1 über eine Regelschaltung in eine Soll-Position zu steuern. Es ist auch möglich, die jeweiligen Ist-Positionen auf einem Bildschirm anzuzeigen oder beliebige andere geeignete Handlungen über sie durchzuführen. Da an den Ausgängen der Addierer 69, 70, 85 bzw. Subtrahierer 71, 72, 89 elektrische Grössen anstehen, die noch von der Intensität des Elektronenstrahls 1 abhängen, können diese Grössen vorteilhaft zur Regelung des Elektronenstroms auf einen gewünschten Sollwert verwendet werden. Dies erfolgt am einfachsten über die Steuerung des Emissionsstroms einer Elektronenstrahlkanone bei konstanter Beschleunigungsspannung.

Die intensitätsabhängigen Grössen können auch dazu verwendet werden, die Bewegung der Folie 19 zu steuern, und zwar derart, dass die auf das Detektorsystem auftreffende Röntgenstrahlintensität nicht unter einen zulässigen Grenzwert absinkt. Bei Erreichen des zum unteren Röntgenstrahlintensitäts-Grenzwert proportionalen Grenzwerts der intensitätsabhängigen Grösse kann eine Erhöhung der kontinuierlichen Schutzfolien-Bewegungsgeschwindigkeit oder die augenblickliche Beförderung eines unbedampften Schutzfolienstückes in den Bereich der Aufdampfblendenöffnung ausgelöst werden.

Die vorstehend beschriebenen Ausführungsbeispiele der Erfindung liessen sich durch weitere vermehren, ohne dass der Schutzumfang der Erfindung verlassen würde. Wenn beispielsweise keine Proportionalität zwischen den x- und y-Koordinaten und den Ausgangsspannungen bzw. -strömen eines Positionsgebers benötigt wird und der Elektronenstrahl nur innerhalb der unmittelbaren Umgebung eines festen Zielpunktes bewegt werden kann, kann im Falle einer einzelnen Lochblende vorgesehen sein, dass der Sensor aus einer Vier-Quadranten-Photodiode besteht. Im Falle der zweifachen Loch- bzw. Schlitzblende ist es möglich, als Detektor zwei rechtwinklig zueinander angeordnete Zwei-Quadranten-Photodioden zu verwenden, wobei jede Photodiode einer Blende zugeordnet ist. Als Quadranten-Photodiode wird hier auch eine entsprechende Anordnung aus diskreten Dioden verstanden.

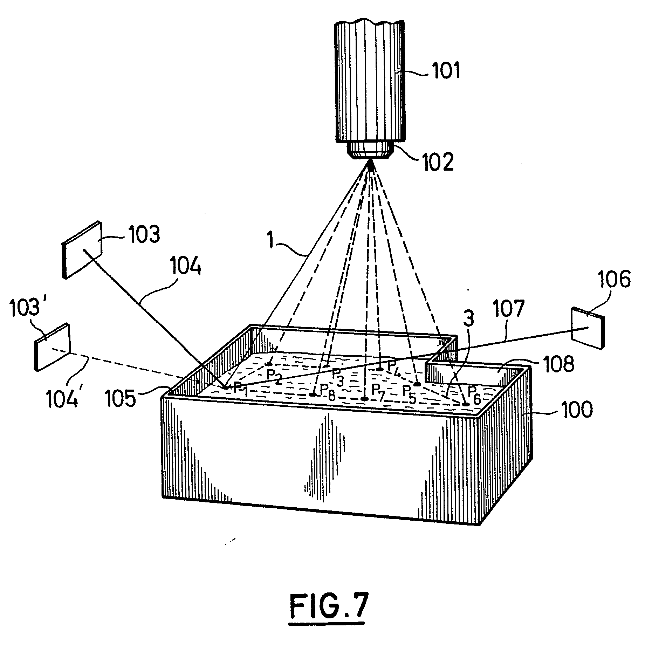

Mit der Erfindung werden, wie bereits erwähnt, alle relevanten Auftreffstellen des Elektronenstrahls 1 auf das Targetmaterial 3 erfasst. In der Fig. 7 ist dieses Targetmaterial 3 in einem Tiegel 100 dargestellt. Auf der Oberfläche des Targetmaterials 3 sind verschiedene Auftreffpunkte $P_1$–$P_8$ angegeben, auf die der Elektronenstrahl 1 nacheinander auftrifft. Die den Auftreffpunkten $P_2$–$P_8$ zugeordneten Positionen des Elektronenstrahls 1, der aus einer Elektronenstrahlkanone 101 kommt und von einem Ablenksystem 102 abgelenkt wird, sind in der Fig. 7 gestrichelt dargestellt.

Wird ein Detektor 103 an der in der Fig. 7 dargestellten Position angeordnet, so kann er alle Auftreffpunkte $P_1$–$P_8$ erfassen.

Beispielsweise wird das von dem Punkt $P_1$ ausgehende Röntgenstrahlbündel 104 voll von ihm erfasst. Ist er jedoch in der Position angeordnet, die durch die Bezugszahl 103' angedeutet ist, so muss die Tiegelwand 105 von den Röntgenstrahlen durchdrungen werden, damit diese auf den Detektor 103' gelangen. Dies ist im allgemeinen unproblematisch, da durch die Tiegelwand 105 noch genügend Röntgenstrahlen dringen, was durch das Strahlenbündel 104' angedeutet ist.

Für den Fall, dass die Röntgenstrahlen durch die Tiegelwand 105 zu stark gedämpft werden, kann ein weiterer Detektor 106 auf der gegenüberliegenden Seite angeordnet werden, der den für den Detektor 103' toten Winkel überwacht. Das Strahlenbündel 107, das von Auftreffpunkt $P_1$ ausgeht, trifft hierbei ohne Durchtritt durch eine Tiegelwand 108 auf den Detektor 106.

Auf entsprechende Weise können an verschiedenen Stellen mehr als zwei Detektoren vorgesehen werden. Die Ausgangssignale dieser Detektoren können miteinander verglichen werden, wodurch eventuelle Fehlmessungen ausgeschaltet werden. Es ist auch möglich, eine Mittelwertbildung der Messdaten verschiedener Detektoren vorzunehmen.

## Patentansprüche

1. Einrichtung zum Erkennen der Auftreffstelle eines Ladungsträgerstrahls auf ein Target, wobei die von der Auftreffstelle ausgehenden Röntgenstrahlen durch einen Detektor erkannt werden, der mit einer Auswerteschaltung verbunden ist, dadurch gekennzeichnet, dass ein Abbildungssystem (5, 50; 10, 11, 12) vorgesehen ist, welches alle Positionen, welche die Auftreffstelle (2) einnehmen kann, erfasst und auf die Sensorfläche eines positionsempfindlichen Detektors (7; 14, 15) abbildet, wobei die abgebildeten Koordinaten (x', y') direkt proportional den Koordinaten (x, y) der Auftreffstelle (2) sind, und dass zwischen Targetfläche (3) und positionsempfindlichem Detektor (7; 14, 15) ein im wesentlichen in dem von der Auftreffstelle (2) emittierten Röntgen-Wellenlängenbereich der von der Auftreffstelle (2) emittierten Strahlung (4; 51, 52) gut durchlässiges Filter (6, 23) angeordnet ist und der Detektor (7; 14, 15) elektrische Signale abgibt, die von den Koordinaten (x', y') monoton abhängen.

2. Einrichtung nach Anspruch 1, dadurch gekennzeichnet, dass das Abbildungssystem (5, 50; 10, 11, 12) eine Trennwand zwischen dem Hochvakuumbereich, in dem sich der Ladungsträgerstrahl (1) und das Target (3) befinden und dem Normaldruckbereich, in dem sich der Detektor (7; 14, 15) befindet, bildet.

3. Einrichtung nach den Ansprüchen 1 oder 2, dadurch gekennzeichnet, dass das Abbildungssystem eine Blende (5) mit einem kreisförmigen Loch (50) enthält.

4. Einrichtung nach den Ansprüchen 1 oder 2, dadurch gekennzeichnet, dass das Abbildungssystem mindestens eine Blende (5) mit zwei kreisförmigen Löchern (50) enthält.

5. Einrichtung nach den Ansprüchen 1 oder 2, dadurch gekennzeichnet, dass das Abbildungssystem mindestens eine Blende (10) mit zwei senkrecht aufeinander stehenden Schlitzen (11, 12) enthält, von denen der eine Schlitz (11) für die Abbildung der x-Koordinate und der andere Schlitz (12) für die Abbildung der y-Koordinate vorgesehen ist.

6. Einrichtung nach einem oder mehreren der vorangegangenen Ansprüche, dadurch gekennzeichnet, dass der positionsempfindliche Detektor (7) eine zweidimensionale Lateraldiode mit vier Elektroden (61, 62, 63, 64) ist.

7. Einrichtung nach einem oder nach mehreren der vorangegangenen Ansprüche, dadurch gekennzeichnet, dass der positionsempfindliche Detektor eine Vier-Quadranten-Photodiode ist.

8. Einrichtung nach einem oder nach mehreren der vorangegangenen Ansprüche, dadurch gekennzeichnet, dass der positionsempfindliche Detektor zwei rechtwinklig zueinander angeordnete eindimensionale Lateraldioden (14, 15) enthält.

9. Einrichtung nach Anspruch 1, dadurch gekennzeichnet, dass das für den Röntgen-Wellenlängenbereich der von der Auftreffstelle (2) emittierten Strahlung (4; 51, 52) gut durchlässige Filter ein Wandler (23) ist, der die Röntgenstrahlen in langwelligere Strahlen umformt.

10. Einrichtung nach Anspruch 9, dadurch gekennzeichnet, dass dicht vor der Sensorfläche des positionsempfindlichen Detektors (7) eine Fluoreszenzschicht (23) angeordnet ist, welche die von der Auftreffstelle (2) ausgehende Röntgenstrahlung in eine elektromagnetische Strahlung umwandelt, für welche der Detektor (7) hohe Empfindlichkeitswerte aufweist.

11. Einrichtung nach Anspruch 10, dadurch gekennzeichnet, dass zwischen der Sensorfläche des positionsempfindlichen Detektors (7) und der Fluoreszenzschicht (23) eine Lichtleiterplatte (22) angeordnet ist.

12. Einrichtung nach Anspruch 1, dadurch gekennzeichnet, dass die Auswerteschaltung die Erfassung einer Koordinate (x, x' bzw. y, y') des Auftreffpunkts (2) zwei von einem Detektor (75) abgegebene Signale ($i_A$, $i_B$) miteinander addiert und voneinander subtrahiert und das entstandene Differenzsignal durch das entstandene Summensignal dividiert.

13. Einrichtung nach den Ansprüchen 1 oder 12, dadurch gekennzeichnet, dass die Auswerteschaltung für die Erfassung zweier Koordinaten (x, x' und y, y') zwei Addierer (69, 70); zwei Subtrahierer (71, 72) und zwei Dividierer (73, 74) aufweist.

14. Einrichtung nach den Ansprüchen 12 oder 13, dadurch gekennzeichnet, dass die Ausgangssignale des Dividierers (93) bzw. der Dividierer (73, 74) für die Regelung der Position der Auftreffstelle (2) des Ladungsträgerstrahls (1) auf einem bestimmten Sollwert der x- und/oder y-Koordinate verwendet wird.

15. Einrichtung nach Anspruch 1, dadurch gekennzeichnet, dass die Auswerteschaltung wenigstens eine Abgriffstelle (95) aufweist, an welcher ein von der Intensität der Röntgenstrahlung abhängiges Signal ansteht, das zur Regelung der Stärke des Ladungsträgerstrahls (1) verwendet wird.

16. Einrichtung nach einem oder mehreren der vorangegangenen Ansprüche, dadurch gekennzeichnet, dass vor einer Blende (5) eine Schutzfolie (19) angeordnet ist, welche die Bedampfung der Blende (5) und/oder des Filters (6) verhindert.

17. Einrichtung nach Anspruch 16, dadurch gekennzeichnet, dass die Schutzfolie (19) die Funktion des Filters (6) übernimmt.

18. Einrichtung nach den Ansprüchen 16 oder 17, dadurch gekennzeichnet, dass die Schutzfolie (19) hinter einer Aufdampf-Blendenöffnung (54) kontinuierlich oder fallweise quer zur Bedampfungsrichtung bewegbar ist.

19. Einrichtung nach Anspruch 18, dadurch gekennzeichnet, dass die Bewegung der Schutzfolie (19) durch ein von der Röntgenstrahlen-Intensität abhängiges und an einen Abgriff (95) der Auswerteschaltung auftretendes Signal derart gesteuert wird, dass die auf den Detektor (7) auftreffende Röntgenstrahlenintensität nicht unter einen zulässigen Grenzwert absinkt.

20. Einrichtung nach Anspruch 16, dadurch gekennzeichnet, dass in Bedampfungsanlagen das zu bedampfende Folienband die Funktion der Schutzfolie (19) übernimmt.

21. Einrichtung nach einem oder nach mehreren der vorangegangenen Ansprüche, dadurch gekennzeichnet, dass mehrere Detektoren (103, 106) an verschiedenen Stellen oberhalb des Targets (3) angeordnet sind.

**Revendications**

1. Dispositif pour l'identification du point d'impact d'un rayon porteur de charge sur une cible, les rayons X sortant à cette occasion du point d'impact étant identifiés au moyen d'un détecteur relié à un circuit d'exploitation, caractérisé en ce qu'un système de représentation (5, 50; 10, 11, 12) est prévu et capte toutes les positions que peut prendre le point d'impact (2) et donne une image sur la surface de capteur d'un détecteur (7; 14, 15) sensible à la position, les coordonnées représentées (x′, y′) étant à cette occasion directement proportionnelles aux coordonnées (x, y) du point d'impact (2), et en ce qu'un filtre (6, 23) bien perméable principalement dans la plage de longueur d'onde des rayons X émis par le point d'impact (2) du rayonnement (4; 51, 52) émis par le point d'impact (2), est disposé entre la surface de cible (3) et le détecteur (7; 14, 15) sensible à la position et que le détecteur (7; 14, 15) délivre des signaux électriques dépendant de manière monotone des coordonnées (x′, y′).

2. Dispositif selon la revendication 1, caractérisé en ce que le système de représentation (5, 50; 10, 11, 12) forme une paroi de séparation entre la zone à vide poussé, dans laquelle se trouvent le rayon porteur de charge (1) et la cible (3), et la zone de pression normale, dans laquelle se trouve le détecteur (7; 14, 15).

3. Dispositif selon la revendication 1 ou 2, caractérisé en ce que le système de représentation comprend un diaphragme (5) avec un trou de forme circulaire (50).

4. Dispositif selon la revendication 1 ou 2, caractérisé en ce que le système de représentation comprend au moins un diaphragme (5) avec deux trous de forme circulaire (50).

5. Dispositif selon la revendication 1 ou 2, caractérisé en ce que le système de représentation comprend au moins un diaphragme (10) avec deux fentes (11, 12) situées perpendiculairement l'une par rapport à l'autre, dont l'une (11) est prévue pour la représentation des coordonnées en x et l'autre fente (12) pour la représentation des coordonnées en y.

6. Dispositif selon une ou plusieurs des revendications précédentes, caractérisé en ce que le détecteur sensible à la position (7) est une diode latérale à deux dimensions possédant quatre électrodes (61, 62, 63, 64).

7. Dispositif selon une ou plusieurs des revendications précédentes, caractérisé en ce que le détecteur sensible à la position est une photodiode à quatre quadrants.

8. Dispositif selon une ou plusieurs des revendications précédentes, caractérisé en ce que le détecteur sensible à la position comprend deux diodes latérales (14, 15) unidimensionnelles réciproquement disposées à angle droit.

9. Dispositif selon la revendication 1, caractérisé en ce que le filtre bien perméable à la plage de longueur d'onde de rayons X du rayonnement (4; 51, 52) émis par le point d'impact (2) est un convertisseur (23) qui convertit les rayons X en rayons de plus grande longueur d'onde.

10. Dispositif selon la revendication 9, caractérisé en ce qu'une couche fluorescente (23) est disposée très près devant la surface de capteur du détecteur sensible à la position (7), couche qui convertit le rayonnement X sortant du point d'impact (2) en un rayonnement électromagnétique auquel le détecteur (7) présente une sensibilité élevée.

11. Dispositif selon la revendication 10, caractérisé en ce qu'une plaque guide lumière (22) est disposée entre la surface de capteur du détecteur sensible à la position (7) et la couche fluorescente (23).

12. Dispositif selon la revendication 1, caractérisé en ce que le circuit d'exploitation pour la saisie d'une coordonnée (x, x′ respectivement y, y′) du point d'impact (2) additionne deux signaux ($i_A$, $i_B$) délivrés par un détecteur (75) et les soustrait l'un de l'autre et divise le signal différentiel apparu par le signal de sommation apparu.

13. Dispositif selon la revendication 1 ou 12, caractérisé en ce que le circuit d'exploitation de deux coordonnées (x, x′ et y, y′) possède deux additionneurs (69, 70); deux soustracteurs (71, 72) et deux diviseurs (73, 74).

14. Dispositif selon la revendication 12 ou 13, caractérisé en ce que les signaux de sortie du diviseur (93), respectivement des diviseurs (73, 74) sont utilisés pour le réglage de la position du point d'impact (2) du rayon porteur de charge (1) à une valeur de consigne déterminée des coordonnées en x et/ou en y.

15. Dispositif selon la revendication 1, caractérisé en ce que le circuit d'exploitation présente au moins un point de prélèvement (95) auquel est appliqué un signal dépendant de l'intensité du rayonnement X, signal utilisé pour le réglage de l'intensité du rayon porteur de charge (1).

16. Dispositif selon une ou plusieurs des revendications précédentes, caractérisé en ce qu'une feuille de protection (19) est disposée devant un diaphragme (5), empêchant la métallisation du diaphragma (5) et/ou du filtre (6).

17. Dispositif selon la revendication 16, caractérisé en ce que la feuille de protection (19) assume la fonction du filtre (6).

18. Dispositif selon la revendication 16 ou 17, caractérisé en ce que la feuille de protection (19) est mobile de manière continue ou coup-à-coup derrière un orifice de diaphragme de métallisation (54), transversalement par rapport à la direction de métallisation.

19. Dispositif selon la revendication 18, caractérisé en ce que le mouvement de la feuille de protection (19) est commandé au moyen d'un signal fonction de l'intensité de rayon X et apparaissant sur un prélèvement (95) du circuit d'exploitation, de façon à ce que l'intensité de rayons X apparaissant sur le détecteur ne descende pas au-dessous de la valeur limite admissible.

20. Dispositif selon la revendication 16, caractérisé en ce que dans les installations de métallisation, la bande de feuille à métalliser assume la fonction de feuille de protection (19).

21. Dispositif selon une ou plusieurs des revendications précédentes, caractérisé en ce que plusieurs détecteurs (103, 106) sont disposés en différents endroits situés au-dessus de la cible (3).

**Claims**

1. Apparatus for detecting the location of incidence of a beam of charged particles on a target, wherein the X-rays starting from the location of incidence are detected by a detector connected with an circuit, characterised in that there is provided an imaging system (5, 50; 10, 11, 12) which senses all positions that can be taken up by the location of incidence (2) and images them on the sensing surface of a position-sensitive detector (7; 14, 15), the imaged co-ordinates (x', y') being directly proportional to the co-ordinates (x, y) of the location of incidence (2), and in that a filter (6, 23) of high transmissivity essentially in the X-ray wavelength range of the radiation emitted by the location of incidence (2) is arranged between the target surface (3) and the position-sensitive detector (7; 14, 15), and delivers electric signals to the detector (7; 14, 15) which are a monotonic function of the imaged co-ordinates (x', y').

2. Apparatus according to claim 1, characterised in that the imaging system (5, 50; 10, 11, 12) forms a separating wall between the high-vacuum region in which the charge carrier beam (1) and the target (3) are disposed, and a normal-pressure region in which the detector (7; 14, 15) is disposed.

3. Apparatus according to claim 1 or 2, characterised in that the imaging system contains a diaphragm (5) with a circular hole (50).

4. Apparatus according to claim 1 or 2, characterised in that the imaging system contains at least one diaphragm (5) with two circular holes (50).

5. Apparatus according to claim 1 or 2, characterised in that the imaging system contains at least one diaphragm (5) with two vertically juxtaposed slits (11, 12) of which one slit (11) is provided for imaging the x-coordinate and the other slit (12) is provided for imaging the y-coordinate.

6. Apparatus according to one or more of the preceding claims, characterised in that the position-sensitive detector (7) is a two-dimensional lateral diode with four electrodes (61, 62, 63, 64).

7. Apparatus according to one or more of the preceding claims, characterised in that the position-sensitive detector is a photodiode with four quadrants.

8. Apparatus according to one or more of the preceding claims, characterised in that the position-sensitive detector contains two mutually orthogonally arranged one-dimensional lateral diodes.

9. Apparatus according to claim 1, characterised in that the filter of good transmissivity for the X-ray wavelength range of the radiation (4; 51, 52) emitted from the location of incidence (2) is a transducer (23) which converts the X-rays to long wave radiation.

10. Apparatus according to claim 9, characterised in that a fluorescent layer (33) is arranged closely in front of the sensing surface of position-sensitive detector (7) to convert the X-rays emitted by the location of incidence (2) into electromagnetic radiation for which the detector (7) has high sensitivity values.

11. Apparatus according to claim 10, characterised in that a light-guide plate (22) is arranged between the sensing surface of position-sensitive detector (7) and the fluorescent layer (23).

12. Apparatus according to claim 1, characterised in that for the detection of a co-ordinate (x, x' or y, y') of the location of incidence (2) the evaluation circuit adds together and subtracts from each other two signals ($i_A$ $i_B$) delivered by the detector (75) and the resulting difference signal is divided by the resulting summation signal.

13. Apparatus according to claim 1 or 12, characterised in that for the detection of two co-ordinates (x, x' and y, y') the evaluation circuit has two adders (69, 70), two subtractors (71, 72) and two dividers (73, 74).

14. Apparatus according to claim 12 or 13, characterised in that the output signals of the divider (93) or dividers (73, 74) are utilised for regulating the position of the location of incidence (2) of the charge carrier beam to a predetermined desired value of the x- and/or y-coordinate(s).

15. Apparatus according to claim 1, characterised in that the evaluating circuit has at least one tap position (95) at which a signal dependent on the intensity of the X-ray radiation is available, which signal is utilised for regulating the intensity of the charge carrier beam (1).

16. Apparatus according to any one or more of the preceding claims, characterised in that a protective foil (19) is arranged in front of the diaphragm (5) to prevent vapour deposition of the diaphragm and/or the filter (6).

17. Apparatus according to claim 16, characterised in that the protective foil (19) takes over the function of the filter (6).

18. Apparatus according to claim 16 or 17, characterised in that the protective foil (19) is displaceable continuously or, if need be, transversely to the direction of vapour deposition behind a vapour deposition diaphragm opening (54).

19. Apparatus according to claim 18, characterised in that the movement of the protective foil (19) is controlled by an X-ray beam intensity-dependent signal arising at a tap (95) of the analysing circuit in such a manner that the intensity of the X-ray beam incident on the detector does not fall below a permissible threshold value.

20. Apparatus according to claim 16, characterised in that in vapour deposition plants the foil strip to be vapour-coated takes over the function of the protective foil (19).

21. Apparatus according to one or more of the preceding claims, characterised in that a plurality of detectors (103, 106) are arranged at various positions over the target (3).

115

# FIG.1

FIG. 2

## FIG.3

## FIG.4

EP 0 184 680 B1

4/5

**FIG.5**

**FIG.6**

17

5/5

**FIG.7**